(19) Europäisches Patentamt

European Patent Office

Office européen des brevets

(11) **EP 2 685 457 B1**

(12) **FASCICULE DE BREVET EUROPEEN**

(45) Date de publication et mention
de la délivrance du brevet:
**28.09.2016 Bulletin 2016/39**

(21) Numéro de dépôt: **13174845.1**

(22) Date de dépôt: **03.07.2013**

(51) Int Cl.:
*G11C 5/14* *(2006.01)*    *G11C 13/02* *(2006.01)*
*G11C 14/00* *(2006.01)*    *H03K 19/007* *(2006.01)*
*G11C 13/00* *(2006.01)*    *G11C 23/00* *(2006.01)*

(54) **Module électronique logique non-volatile**

Nicht-flüchtiges elektronisches Logikmodul

Non-volatile logic electronic module

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.07.2012 FR 1256572**

(43) Date de publication de la demande:
**15.01.2014 Bulletin 2014/03**

(73) Titulaire: **COMMISSARIAT A L'ENERGIE
ATOMIQUE ET AUX
ENERGIES ALTERNATIVES
75015 Paris (FR)**

(72) Inventeurs:
• **Buckley, Julien
38000 Grenoble (FR)**
• **Ben Jamaa, Haykel
38000 Grenoble (FR)**

(74) Mandataire: **Lebkiri, Alexandre
Cabinet Camus Lebkiri
25, Rue de Maubeuge
75009 Paris (FR)**

(56) Documents cités:
**US-A1- 2009 243 653**

**Description**

**DOMAINE TECHNIQUE**

La présente invention se rapporte à un module logique intégrant un circuit logique réalisant une fonction logique de type combinatoire ou séquentielle, et possédant un module de sauvegarde non-volatile de la valeur calculée par le module logique.

**ETAT DE LA TECHNIQUE ANTERIEURE**

De façon connue, un module logique est un dispositif réalisant une fonction logique et comprenant généralement plusieurs entrées et une ou plusieurs sorties, chaque sortie étant obtenue en effectuant une ou plusieurs opérations logiques binaires sur les entrées. Parmi les fonctions logiques, on distinguera les fonctions logiques « combinatoires », bases du calcul booléen, qui résultent de l'analyse combinatoire des variations des grandeurs d'entrées uniquement et les fonctions logiques « séquentielles » ou bascules, qui résultent de l'association de plusieurs fonctions logiques « combinatoires » et qui supposent l'existence d'une "horloge" qui donne le tempo; les valeurs de sorties dépendent non seulement des valeurs d'entrée, mais aussi de l'instant où elles sont mesurées (avant ou après la synchronisation par l'horloge).

Il convient de noter que lorsqu'une donnée d'entrée est modifiée alors la sortie réagit immédiatement au temps de propagation près. Cette particularité pose des inconvénients. En effet, lorsqu'une coupure de courant se produit, alors les informations de sortie sont perdues. Cette coupure d'alimentation peut être involontaire mais elle peut également être volontaire de façon à pouvoir diminuer la consommation globale du circuit.

**EXPOSE DE L'INVENTION**

Un but de l'invention est de fournir un module logique permettant d'enregistrer et de restaurer les signaux après coupure de l'alimentation. Un autre but de l'invention est de fournir un module logique de consommation réduite.

A cette fin, l'invention concerne un module logique comportant :

- des moyens de mise en oeuvre d'une fonction logique, lesdits moyens comportant au moins une entrée et au moins une sortie, ladite au moins une sortie représentant au moins partiellement le résultat de ladite fonction logique,
- au moins un premier élément comportant au moins un état résistif,
- au moins un deuxième élément formé par une mémoire résistive bipolaire,
- ledit premier élément et ledit deuxième élément ayant une électrode commune reliée à ladite sortie.

On entend pour la suite de la description par mémoire résistive bipolaire (ou point mémoire bipolaire) une mémoire présentant un fonctionnement bipolaire au cours duquel une première tension peut lui être appliquée pour passer d'un état hautement résistif OFF à un état faiblement résistif ON et une deuxième tension, de sens opposée à la première, peut lui être appliquée pour passer de l'état faiblement résistif ON à l'état hautement résistif OFF. Une telle mémoire est par exemple une mémoire RRAM (ou « Resistive RAM ») bipolaire telle que les mémoires à ponts conducteurs ioniques CBRAM (pour *Conductive Bridge Random Access Memory en anglais).*

Grâce à l'invention, lors d'une coupure de l'alimentation du module logique, les signaux préalablement enregistrés sur au moins le premier élément ayant une électrode commune avec le deuxième élément sont conservés de sorte que lesdits signaux préalablement enregistrés puissent être restaurés lors de la mise sous tension du module logique. Cette coupure d'alimentation peut être involontaire mais elle peut également être volontaire de façon à pouvoir diminuer la consommation globale du circuit que comporte un tel module tout en assurant la restauration des signaux enregistrés.

Le deuxième élément peut lui-même être un élément purement résistif (i.e. une résistance ohmique ou un transistor en mode résistif) ou une mémoire résistive bipolaire telle qu'une RRAM (ou « Resistive RAM ») bipolaire.

Selon les tensions appliquées aux bornes non communes du premier et du deuxième élément connectés à ladite sortie, le module logique peut être utilisé selon différents modes de fonctionnement :

- un mode inactif au cours duquel la mémoire résistive bipolaire est hautement résistive de manière à ne pas perturber la mise en oeuvre de la fonction logique ;
- un mode de sauvegarde au cours duquel le signal de sortie du module logique est sauvegardé selon une configuration résistive particulière des premier ou deuxième éléments ;
- un mode de restauration au cours duquel le signal sauvegardé est restauré à ladite sortie du module logique.

Le module logique selon l'invention peut également présenter une ou plusieurs des caractéristiques ci-dessous, considérées individuellement ou selon toutes les combinaisons techniquement réalisables :

- le premier élément est une résistance ohmique ou un transistor ;
- le premier élément est une mémoire résistive bipolaire, le premier élément et ledit deuxième élément étant agencés en série et selon un sens identique de polarité ;
- les tensions appliquées sur les électrodes respectives non communes desdits premier et deuxième éléments sont programmées selon un ou plusieurs cycles d'horloge de sorte que le module logique présente trois modes de fonctionnement :

  - un mode inactif au cours duquel le premier élément et le deuxième élément sont dans un état de haute résistance, dit état résistif haut de sorte que lesdits premier et deuxième éléments ne perturbent pas la mise en oeuvre de la fonction logique,
  - un mode de sauvegarde au cours duquel le dernier résultat de la fonction logique est sauvegardé en fonction d'un état résistif donné desdits premier élément et deuxième élément,
  - un mode de restauration suivant le mode de sauvegarde au cours duquel le dernier résultat sauvegardé est restauré sur ladite sortie ;

- chaque mémoire résistive bipolaire est choisie parmi les mémoires suivantes :

  - mémoire CBRAM ;
  - mémoire OxRAM bipolaire;
  - mémoire MEMS;
  - mémoire NEMS.

- le premier élément et le deuxième élément sont disposés entre un premier niveau de métallisation et un deuxième niveau de métallisation, le premier niveau de métallisation étant le niveau de métallisation le plus bas.

Dans une réalisation non limitative :

- l'électrode du premier élément différente de l'électrode commune est connectée au premier niveau de métallisation, ledit premier niveau de métallisation formant l'arrivée de la ligne d'alimentation MVDD,
- l'électrode du deuxième élément différente de ladite électrode commune est connectée au premier niveau de métallisation, ledit premier niveau de métallisation formant l'arrivée de la ligne d'alimentation MVSS, et
- ladite sortie est formée par le premier niveau de métallisation.

Dans une réalisation différente également non limitative:

- l'électrode du premier élément différente de l'électrode commune est connectée au deuxième niveau de métallisation, ledit deuxième niveau de métallisation formant l'arrivée de la ligne d'alimentation MVDD,
- l'électrode du deuxième élément différente de ladite électrode commune est connectée au deuxième niveau de métallisation, ledit deuxième niveau de métallisation formant l'arrivée de la ligne d'alimentation MVSS, et
- ladite sortie est formée par le deuxième niveau de métallisation et est connectée à l'électrode commune.

Dans une autre réalisation non limitative, le premier élément et le deuxième élément sont disposés entre deux niveaux de métallisation intermédiaires ou supérieurs.
Dans une réalisation non limitative de l'invention, le module logique selon l'invention comporte :

- une pluralité de sorties, ladite pluralité de sorties représentant le résultat de ladite fonction logique,
- une pluralité de premiers éléments,
- une pluralité de deuxièmes éléments,
- chaque sortie étant reliée à une électrode commune d'un premier élément et d'un deuxième élément.

**BREVE DESCRIPTION DES FIGURES**

D'autres caractéristiques et avantages de l'invention ressortiront clairement de la description qui en est donnée ci-après, à titre indicatif et nullement limitatif, en référence aux figures annexées ci-jointes, parmi lesquelles :

- la figure 1 illustre de façon schématique un premier mode de réalisation d'un module logique conforme à l'invention ;
- la figure 2 illustre de façon schématique un deuxième mode de réalisation d'un module logique conforme à l'invention ;
- la figure 3 illustre un synoptique des étapes d'un procédé de contrôle du mode de fonctionnement d'un module logique conforme à celui illustré sur les figures 1 ou 2,
- la figure 4 illustre de façon schématique un troisième mode de réalisation d'un module logique conforme à l'invention ;
- la figure 5 illustre un synoptique des étapes d'un procédé de contrôle du mode de fonctionnement d'un module logique conforme à celui illustré sur la figure 3 ;
- la figure 6 illustre de façon schématique un quatrième mode de réalisation d'un module logique conforme à l'invention ;
- la figure 7 illustre un premier mode de réalisation des niveaux de métallisation d'un module logique selon l'invention ;
- la figure 8 illustre un deuxième mode de réalisation des niveaux de métallisation d'un module logique selon l'invention ;
- la figure 9 illustre un troisième mode de réalisation des niveaux de métallisation d'un module logique selon l'invention.

Pour des raisons de clarté, seuls les éléments essentiels pour la compréhension de l'invention ont été représentés, et ceci sans respect de l'échelle et de manière schématique.

## DESCRIPTION D'AU MOINS UN MODE DE REALISATION DE L'INVENTION

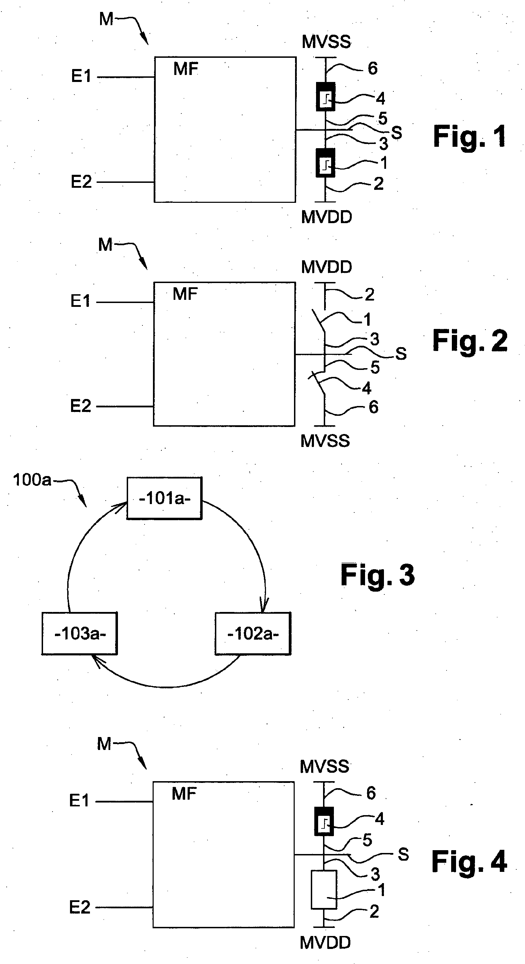

La figure 1 illustre un premier mode de réalisation d'un module logique M selon l'invention.
Le module logique M comporte :

- des moyens de mise en oeuvre d'une fonction logique MF, les moyens MF comportant deux entrées E1, E2 et une unique sortie S représentant le résultat de la fonction logique,
- un premier élément 1 formé par une mémoire résistive bipolaire comportant une première électrode 2 et une deuxième électrode 3, et
- un deuxième élément 4 formé par une mémoire résistive bipolaire comportant une troisième électrode 5 et une quatrième électrode 6.

On notera que les moyens de mise en oeuvre d'une fonction logique MF constituent un circuit logique réalisant une fonction logique ; le nombre d'entrée a été donné à titre purement illustratif étant entendu que le module peut n'avoir qu'une seule entrée (cas d'un inverseur par exemple) ou un nombre d'entrée strictement supérieur à deux. De façon non limitative, les moyens de mise en oeuvre d'une fonction logique MF sont formés selon une technologie de type CMOS (pour *Complementary Metal Oxide Semiconductor*).
Le premier élément 1 et le deuxième élément 4 sont des mémoires non volatiles qui conservent leurs état résistif (état qui représentent un état de la mémoire) en l'absence d'alimentation électrique.
En outre, le premier élément 1 et le deuxième élément 4 présentent une électrode commune formée par la deuxième électrode 3 et la troisième électrode 5 ; la deuxième électrode 3 et la troisième électrode 5 communes sont en outre reliées à une sortie S du module MF. Il convient de noter que le premier élément 1 et le deuxième élément 4 sont agencés en série et selon un même sens de polarité.
Chaque élément à commutation résistive bipolaire peut être formé par une RRAM bipolaire (pour *Resistive Random Acess Memory*) de type CBRAM (pour *Conductive Bridge Random Access Memory*) ou de type OxRAM bipolaire (pour *Oxide Random Access Memory)* ; selon les technologies utilisées, les mémoires OxRAM peuvent être bipolaires ou unipolaires ; selon l'invention, seules les OxRAM bipolaires sont utilisables.
De façon générale, une mémoire RRAM est dite à commutation résistive bipolaire lorsque sa tension de SET permettant de passer d'un état hautement résistif à un état faiblement résistif est de polarité opposée à sa tension de RESET permettant de passer de l'état faiblement résistif à l'état hautement résistif de sorte que les deux états ne peuvent pas être programmés selon une même polarité.
A titre illustratif, le fonctionnement des dispositifs de type CBRAM est basé sur la formation, au sein d'un électrolyte solide, d'un ou plusieurs filaments métalliques (appelés également « dendrite ») entre deux électrodes, lorsque ces électrodes sont portées à des potentiels respectifs appropriés. La formation du filament permet d'obtenir une conduction électrique donnée entre les deux électrodes. En modifiant les potentiels respectifs appliqués aux électrodes, il est possible de modifier la répartition du filament, et de modifier ainsi la conduction électrique entre les deux électrodes. En inversant par exemple le potentiel entre les électrodes, il est possible de faire disparaître ou de réduire le filament métallique, de manière à supprimer ou à réduire considérablement la conduction électrique due à la présence du filament. Les dispositifs CBRAM peuvent ainsi avoir un fonctionnement à deux états : un état dit « ON » et un état dit « OFF » et jouer ainsi le rôle de cellules mémoires. Le dispositif CBRAM est formé par un empilement de type Métal / Conducteur ionique / Métal et comporte un électrolyte solide par exemple à base de chalcogénure dopé tel que du GeS disposé

EP 2 685 457 B1

entre une électrode inerte par exemple en Pt et une électrode soluble comportant une portion de métal ionisable, par exemple à base d'Ag ou de Cu, c'est-à-dire une portion de métal pouvant facilement former des ions métalliques (ici des ions argent Ag$^+$ ou Cu$^{2+}$). L'état mémoire d'un dispositif mémoire CBRAM résulte de la différence de résistivité électrique entre deux états : ON et OFF. A l'état OFF, les ions métalliques (par exemple ici des ions Ag+ pour une électrode soluble en Ag) issus de la portion de métal ionisable sont dispersés dans tout l'électrolyte solide. Ainsi, aucun contact électrique n'est établi entre la portion de métal ionisable et l'électrode inerte. L'électrolyte solide forme une zone électriquement isolante de grande résistivité entre l'anode et la cathode.

Lorsqu'un potentiel V positif est appliqué sur l'électrode soluble, une réaction d'oxydo-réduction a lieu à cette électrode, créant des ions mobiles.

Dans le cas d'une électrode d'Argent, la réaction suivante a lieu :

$$Ag \rightarrow Ag^+ + e^-.$$

Il faut pour cela que le potentiel V appliqué à l'électrode soluble soit supérieur au potentiel redox de l'électrode en question (généralement de l'ordre de plusieurs centaines de mV).

Les ions se déplacent alors dans l'électrolyte sous l'effet du champ électrique appliqué. La vitesse de déplacement dépend de la mobilité de l'ion dans l'électrolyte en question, ce qui guide le choix du couple électrode soluble / électrolyte (exemples : Ag/GeS ; Cu/SiO2...). Les vitesses de déplacement des ions sont de l'ordre du nm/ns.

Arrivés à l'électrode inerte, les ions sont réduits de par la présence d'électrons fournis par l'électrode, entraînant la croissance d'un filament métallique selon la réaction suivante :

$$Ag^+ + e^- \rightarrow Ag$$

Ce filament croit préférentiellement dans la direction de l'électrode soluble.

La mémoire passe alors dans l'état ON lorsque le filament permet le contact entre les deux électrodes, rendant l'empilement conducteur. Cette phase est appelé SET de la mémoire.

Pour passer à l'état OFF (phase de RESET de la mémoire), une tension V négative est appliquée sur l'électrode soluble, entrainant la dissolution du filament conducteur. Pour justifier cette dissolution, des mécanismes thermiques (échauffement) et d'oxydoréduction sont généralement invoqués.

Selon l'invention, le premier élément 1 CBRAM et le second élément 4 CBRAM étant agencés en série et selon un même sens de polarité, l'électrode inerte du premier élément 1 sera donc reliée à l'électrode soluble du second élément 4, ce point commun étant lui-même relié à la sortie S.

Dans un deuxième mode de réalisation particulier de l'invention illustré sur la figure 2, le premier élément 1 est formé par une mémoire résistive bipolaire de type commutateur NEMS (pour *Nano Electro-Mechanical Systems)* ou MEMS (pour Micro *Electro Mechanical Systems)* et le deuxième élément 4 est également formé par une mémoire résistive bipolaire de type commutateur NEMS ou MEMS.

Une mémoire NEMS ou MEMS est dite à commutation résistive bipolaire lorsque sa tension de SET permettant de passer d'un état hautement résistif à un état faiblement résistif est de polarité opposée à sa tension de RESET permettant de passer de l'état faiblement résistif à l'état hautement résistif de sorte que les deux états ne peuvent pas être programmés selon une même polarité.

Dans le cas des commutateurs NEMS/MEMS, la bipolarité est assurée par une lamelle qui peut être mise en contact avec une électrode lorsque la tension appliquée entre la lamelle et l'électrode est supérieure à une tension seuil réduisant ainsi la résistance entre cette lamelle et l'électrode à une résistance quasiment nulle. Lorsque cette tension est inférieure à la tension seuil alors la lamelle se détache de l'électrode et la résistance entre la lamelle et l'électrode est quasiment infinie.

De façon générale et dans les deux modes de réalisation précités illustrés aux figures 1 et 2, il convient de noter que les tensions appliquées sur les électrodes respectives non communes (formées par la première électrode 2 et la quatrième électrode 6 des premier et deuxième éléments 1 et 4 sont programmées selon un ou plusieurs cycles d'horloge de sorte que le module logique M présente trois modes de fonctionnement :

-    un mode inactif au cours duquel le premier élément 1 et le deuxième élément 4 sont dans un état de haute résistance, dit état résistif haut OFF, de sorte que les premier et deuxième éléments 1 et 4 ne perturbent pas la mise en oeuvre de la fonction logique ;
-    un mode de sauvegarde au cours duquel le dernier résultat de la fonction logique est sauvegardé en fonction d'un état résistif donné du premier élément 1 et du deuxième élément 4 ;
-    un mode de restauration suivant généralement le mode de sauvegarde au cours duquel le dernier résultat sauvegardé est restauré sur la sortie S.

5

Par soucis de simplification, nous avons considéré dans ce qui suit des mémoires RRAM présentant des caractéristiques identiques étant entendu que l'invention s'applique également avec des mémoires résistives bipolaires présentant des caractéristiques non nécessairement identiques.

Afin d'assurer ces trois modes de fonctionnement inactif, sauvegarde er restauration, les conditions suivantes peuvent être définies :

- une tension de référence $V_{DD}$ est définie, cette tension de référence étant comprise par exemple entre 0,6V et 1,2V de façon à être compatible avec la technologie CMOS pouvant être utilisée pour former les moyens de mise en oeuvre d'une fonction logique MF ;
- $0.5 \times V_{DD} > |V_{ON}|$, $V_{ON}$ permettant aux premier et deuxième éléments à commutation résistive bipolaire 1, 4 d'être dans un état résistif bas ON (tension de SET générant une résistance $R_{ON}$) ;
- $0.5 \times V_{DD} > |V_{OFF}|$, $V_{OFF}$ permettant aux premier et deuxième éléments à commutation résistive bipolaire 1, 4 d'être dans un état résistif haut OFF (tension de RESET générant une résistance $R_{OFF}$) ;
- $(R_{OFF}/R_{ON}) > 10^3$ ou $10^4$. Le rapport $(R_{OFF}/R_{ON})$ peut également être strictement supérieur à 100 voire même à 10 sans pour autant sortir du cadre de l'invention. $R_{ON}$ peut être de l'ordre de 1k$\Omega$. Dans le cas des commutateurs de type NEMS, cette résistance $R_{ON}$ peut être de l'ordre de 1$\Omega$. Il convient de noter que plus la valeur de $R_{ON}$ est faible et plus le module logique M est rapide. La valeur inférieure limite du rapport $R_{OFF}/R_{ON}$ est donnée par la marge à l'entrée du module logique M. Si la marge sur ce module est q=25%, alors il suffit de prendre $(R_{OFF}/R_{ON}) > 1/q = 1/0.25 = 4$. Il est important de maximiser $(R_{OFF}/R_{ON})$, car un faible rapport signifie une fuite importante, et/ou un module logique plus lent. Cette condition garantie le fonctionnement du mode restauration.

En outre, les conditions suivantes peuvent également être définies :
-

$$R_{ON}/R_{T,ON} > |V_{OFF}|/(0.5 \times V_{DD} - |V_{OFF}|),$$

et
-

$$R_{ON}/R_{T,ON} > |V_{ON}|/(0.5 \times V_{DD} - |V_{ON}|) ;$$

avec $R_{T,ON}$ la résistance à l'état passant des transistors qui sont utilisés dans la technologie CMOS.

Ces deux dernières conditions facilitent le fonctionnement du mode sauvegarde.

Dans un premier mode de mise en oeuvre, la valeur résistive $R_{ON}$ du premier élément à commutation résistive bipolaire 1 est égale à la valeur résistive $R_{ON}$ du deuxième élément à commutation résistive bipolaire 4. Dans ce cas, le module logique M est symétrique.

Dans un second mode de mise en oeuvre, le module logique M est asymétrique de telle sorte que la valeur résistive $R_{ON}$ du premier élément à commutation résistive bipolaire 1 est différente de la valeur résistive $R_{ON}$ du deuxième élément à commutation résistive bipolaire 4. Dans ce cas, on choisira la résistance $R_{ON}$ la plus grande parmi les deux éléments 1 et 4.

L'invention porte également sur un procédé de contrôle du mode de fonctionnement d'un module logique M conforme à ceux illustrés sur les figures 1 et 2 permettant de passer d'un mode de fonctionnement à un autre. La succession des opérations est illustrée par le procédé 100a sur la figure 3 ; le procédé 100a comporte ainsi une première étape 101a de mise en oeuvre du mode inactif au cours de laquelle le premier élément 1 et le deuxième élément 4 sont dans un état de haute résistance, de sorte que les premier et deuxième éléments 1 et 4 ne perturbent pas la mise en oeuvre de la fonction logique, Pour ce faire :

- un premier cycle d'horloge est déclenché au cours duquel la tension MVDD appliquée à l'électrode 2 du premier élément 1 différente de la borne commune (formée par les électrodes 3 et 5) est égale à 1,5 fois la tension de référence VDD et la tension MVSS appliquée à l'électrode 6 du deuxième élément 4 différente de la borne commune (formée par les électrodes 3 et 5) est égale à 0,5 fois la tension de référence VDD,
- un deuxième cycle d'horloge est déclenché au cours duquel la tension MVDD est égale à 0,5 fois la tension de référence VDD et la tension MVSS est égale à -0,5 fois la tension de référence VDD, puis optionnellement
- un troisième cycle d'horloge est déclenché au cours duquel,

  - la tension MVDD est égale à la tension de référence VDD et la tension MVSS est égale à zéro, ou
  - la tension MVDD et la tension MVSS sont flottantes.

Ces trois cycles d'horloge assurent que les premier et deuxième éléments 1 et 4 sont hautement résistifs (i.e. quelle que soit la valeur en sortie S), et donc ne ralentissent pas le fonctionnement du module logique M. Ainsi, au cours de ce mode de fonctionnement inactif le module logique M peut fonctionner de façon classique et effectuer des opérations logiques sans être affecté par des valeurs trop faibles des résistances des mémoires 1 et 4.

De façon à ce que la résistance de chacun des premier élément 1 et deuxième élément 4 soit haute, un nombre de cycles d'horloge plus important peut s'avérer nécessaire. Le nombre de cycles nécessaires est alors déterminé statiquement (par une étude statistique du taux d'activité de tous les modules logiques M que comporte le circuit où se trouve le module logique en question) ou par un monitoring du courant qui passe par les éléments à commutation résistive bipolaire 1 et 4. Tant qu'un courant passe au travers d'un des éléments à commutation résistive bipolaire 1 ou 4 après un cycle d'horloge, on sait qu'au moins l'un des éléments à commutation résistive bipolaire 1 ou 4 n'est pas hautement résistif. Dans ce cas, un cycle d'horloge supplémentaire doit être déclenché.

Le procédé 100a illustré sur la figure 3 comporte en outre une deuxième étape 102a de mise en oeuvre du mode sauvegarde au cours de laquelle des polarités spécifiques sont appliquées aux bornes non communes 3, 5 du premier élément 1 et du deuxième élément 4 afin que le dernier résultat de la fonction logique soit sauvegardé. Cette étape est préférentiellement déclenchée lorsqu'on souhaite couper l'alimentation du module et donc stopper les calculs logiques effectués par le module logique.

Lors de cette deuxième étape 102a, la tension MVDD appliquée à la borne 2 non commune du premier élément 1 est égale à 0,5 fois la tension de référence VDD et la tension MVSS appliquée à la borne 6 non commune du deuxième élément 4 est égale à 0,5 fois la tension de références VDD.

En outre, une période déterminée est nécessaire pour assurer que la sauvegarde ait lieu, suite à quoi le module logique M est éteint. Cette période déterminée est égale au temps minimal pour écrire sur un élément à commutation résistif bipolaire, ce temps minimal étant par exemple supérieur à 10 microsecondes.

D'une manière générale, le mode sauvegarde permet aux éléments à commutation résistive bipolaire 1 et 4 de changer d'état résistif en fonction de la sortie. Donc, les éléments à commutation résistive bipolaire 1 et 4 suivent le fonctionnement du module logique M.

Dès lors que la sauvegarde est réalisée, l'alimentation des premier et deuxième éléments 1 et 4 et du module MF peut être coupée.

A titre d'exemple, si la sortie S à sauvegarder est égale à un 1 logique (c'est-à-dire un potentiel sensiblement égal à VDD sur S) ; dans ce cas, le premier élément 1 aura une résistance $R_{ON}$ (tension positive appliquée à ses bornes) et le deuxième élément 4 aura une résistance $R_{OFF}$ (tension négative appliquée à ses bornes). Cette configuration ($R_{ON}$ pour le premier élément 1 et $R_{OFF}$ pour le deuxième élément 4) correspond à la sauvegarde de la valeur logique 1 sur la sortie S.

A l'inverse, si la sortie S à sauvegarder est égale à un 0 logique (c'est-à-dire un potentiel sensiblement égal à la masse VSS sur S) ; dans ce cas, le premier élément 1 aura une résistance $R_{OFF}$ (tension négative appliquée à ses bornes) et le deuxième élément 4 aura une résistance $R_{ON}$ (tension positive appliquée à ses bornes). Cette configuration ($R_{OFF}$ pour le premier élément 1 et $R_{ON}$ pour le deuxième élément 4) correspond à la sauvegarde de la valeur logique 0 sur la sortie S.

Une fois que l'opération de sauvegarde est réalisée, le mode restauration peut être déclenché à tout moment. Le procédé 100a comporte donc une troisième étape 103a de mise en oeuvre du mode restauration au cours de laquelle le dernier résultat sauvegardé est restauré sur la sortie S. Pour ce faire, au premier cycle d'horloge,

- on polarise la borne 2 non commune du premier élément 1 à une tension égale à la tension de référence VDD, et
- on polarise la borne 6 non commune du deuxième élément 4 à une tension égale à zéro.

A titre illustratif, si la valeur logique 1 est à restaurer sur la sortie S, cela signifie que le premier élément 1 a une résistance $R_{ON}$ et le deuxième élément 4 a une résistance $R_{OFF}$. Dans ce cas, la sortie S va « recopier » le potentiel de MVDD (car la résistance entre S et MVDD est très faible) et se retrouver sensiblement à VDD (valeur logique 1).

A l'inverse, si la valeur logique 0 est à restaurer sur la sortie S, cela signifie que le premier élément 1 a une résistance $R_{OFF}$ et le deuxième élément 4 a une résistance $R_{ON}$. Dans ce cas, la sortie S va « recopier » le potentiel de MVSS (car la résistance entre S et MVSS est très faible) et se retrouver sensiblement à la masse VSS (valeur logique 0).

Le mode restauration a pour fonction de restaurer l'état sauvegardé dans le mode sauvegarde en le rétablissant dans le module logique M et est effectué en utilisant l'état de résistivité de chacun des premier et deuxième éléments 1 et 4 tel que sauvegardé précédemment.

En outre, une période déterminée est nécessaire pour assurer que la restauration ait lieu. Cette période déterminée est égale au temps minimal pour rétablir la sortie et est compris par exemple entre 1 et 10 nanosecondes.

Au cours des cycles d'horloge suivants, l'un des trois modes est déclenché, préférentiellement le mode inactif (Cf. figure 3).

La figure 4 illustre un troisième mode de réalisation d'un module logique M selon l'invention.

Le module logique M comporte :

- des moyens de mise en oeuvre d'une fonction logique MF, les moyens MF comportant deux entrées E1, E2 et une unique sortie S représentant le résultat de la fonction logique,
- un premier élément 1 formé par une résistance ohmique comportant une première électrode 2 et une deuxième électrode 3,
- un deuxième élément 4 formé par une mémoire résistive bipolaire comportant une troisième électrode 5 et une quatrième électrode 6.

En outre, le premier élément 1 et le deuxième élément 4 présentent une électrode commune formée par la deuxième électrode 3 et la troisième électrode 5, la deuxième électrode 3 et la troisième électrode 5 étant reliées à la sortie S. Il convient de noter que la résistance ohmique 1 et le deuxième élément 4 sont agencés en série et selon un même sens de polarité.

De façon comparative au mode de réalisation représenté sur la figure 1, la résistance ohmique 1 permet de rendre le module logique M plus compact. Cette résistance peut par exemple être une résistance de type poly-Si ou silicium implanté ou un transistor branché en diode ou fonctionnant en mode linéaire.

Pour la suite de la description, on suppose que la résistance ohmique 1 est traversée par la tension MVDD. Il est toutefois entendu que la résistance ohmique 1 peut être traversée par la tension MVSS sans pour autant sortir du cadre de l'invention.

Afin d'assurer les trois modes de fonctionnement inactif, sauvegarde et restauration, les conditions suivantes peuvent être définies :

- une tension de référence $V_{DD}$ est définie, cette tension de référence étant comprise par exemple entre 0,6V et 1,2V de façon à être compatible avec la technologie CMOS pouvant être utilisée pour former les moyens de mise en oeuvre d'une fonction logique MF ;
- $0.5 \times V_{DD} > |V_{OFF}|$, $V_{OFF}$ permettant au deuxième élément 4 d'être dans un état résistif haut ;
- La valeur résistive de la résistance ohmique est $R_0 > (1/q-1) \times R_{T,ON}$ avec q l'erreur tolérée sur l'entrée des moyens MF suivant en pourcentage de la tension $MV_{DD}$ pour que le signal de sortie reste interprété correctement, et $R_{T,ON}$ la résistance du n-MOS du module logique M à l'état passant. Par exemple, si q = 25%, alors $R_0 > 3 \times R_{T,ON}$. Pour garantir un fonctionnement du module logique rapide, la valeur résistive de $R_0$ est généralement choisie 5 à 10 fois plus élevée que la valeur résistive $R_{T,ON}$. Toutefois, si l'objectif est de minimiser le courant de fuite, alors la valeur résistive de $R_0$ doit être au moins 10 à 100 fois plus élevée que la valeur résistive $R_{T,ON}$ ; et
- $R_{ON} < R_O < R_{OFF}$ : cette condition assure le fonctionnement correct du mode restauration.

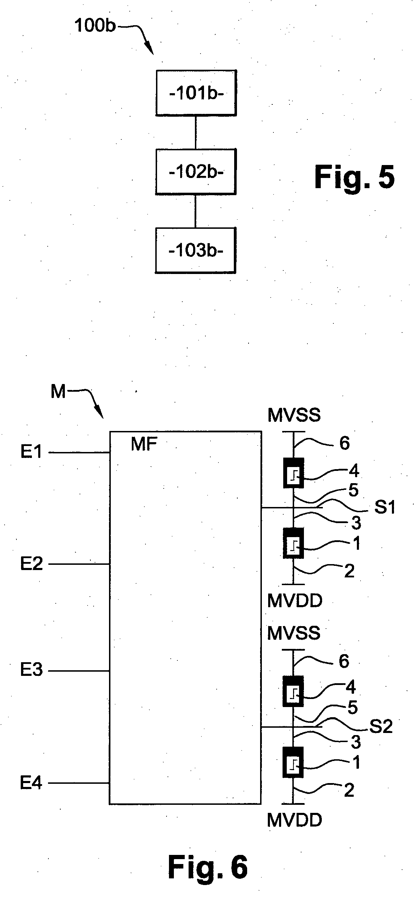

L'invention porte également sur un procédé de contrôle du mode de fonctionnement d'un module logique conforme à celui illustré sur la figure 4 permettant de passer d'un mode de fonctionnement à l'autre. La succession des opérations est illustrée par le procédé 100b sur la figure 5 ; le procédé 100b comporte ainsi une première étape 101b de mise en oeuvre du mode inactif au cours de laquelle le deuxième élément 4 est dans un état de haute résistivité de sorte que le deuxième élément 4 ne perturbe pas la mise en oeuvre de la fonction logique, Pour ce faire :

- un premier cycle d'horloge est déclenché au cours duquel la tension MVDD appliquée à l'électrode 2 de la résistance ohmique 1 différente de la borne commune (formée par les électrodes 3 et 5) est égale à 1,5 fois la tension de référence VDD et la tension MVSS appliquée à l'électrode 6 du deuxième élément 4 différente de la borne commune (formée par les électrodes 3 et 5) est égale à 0,5 fois la tension de référence VDD,
- un deuxième cycle d'horloge est déclenché au cours duquel la tension MVDD est égale à 0,5 fois la tension de référence VDD et la tension MVSS est égale à -0,5 fois la tension de référence VDD, puis optionnellement
- un troisième cycle d'horloge est déclenché au cours duquel,

  - la tension MVDD est égale à la tension de référence VDD et la tension MVSS est égale à zéro, ou
  - la tension MVDD et la tension MVSS sont flottantes.

Le mode inactif assure que le deuxième élément 4 est hautement résistif, et donc ne ralentit pas le fonctionnement du module logique M.

Dans le cas où la résistance ohmique 1 est remplacée par un transistor, alors le transistor doit être polarisé d'une manière modérée, c'est-à-dire avec une tension $|V_{GS}|$ entre grille et source du transistor comprise entre la tension seuil de référence admissible par le transistor $|V_T|$ et $(V_{DD}-|V_T|)$. Dans ce cas, dès que les deux premiers cycles d'horloge sont terminés, le transistor peut être éteint.

De façon à ce que la résistivité du deuxième élément 4 soit haute, un nombre de cycles d'horloge plus important peut s'avérer nécessaire. Le nombre de cycles qui sont nécessaires pour que la sortie S change d'état est alors déterminé statiquement (par une étude statistique du taux d'activité de tous les modules logiques M que comporte le circuit (non représenté) où se trouve le module logique en question) ou par un monitoring du courant qui passe par le deuxième élément à commutation résistive bipolaire 4. Tant qu'un courant passe au travers du deuxième élément à commutation résistive bipolaire après un cycle d'horloge, on sait que ce dernier n'est pas hautement résistif. Dans ce cas, un cycle d'horloge supplémentaire doit être déclenché.

Le procédé 100b illustré sur la figure 5 comporte également une deuxième étape 102b de mise en oeuvre du mode sauvegarde au cours de laquelle des polarités spécifiques sont appliquées aux bornes non communes de la résistance ohmique 1 et du deuxième élément 4 afin que le dernier résultat de la fonction logique soit sauvegardé. Cette étape 102b est préférentiellement déclenchée lorsque l'on souhaite couper l'alimentation du module et donc stopper les calculs logiques effectués par le module logique.

Lors de cette deuxième étape 102b, la tension MVDD appliquée à la borne 2 non commune de la résistance ohmique 1 est égale à 0,5 fois la tension de référence VDD et la tension MVSS appliquée à la borne 6 non commune du deuxième élément 4 est égale à 0,5 fois la tension de références VDD.

En outre, une durée minimale est nécessaire pour assurer que la sauvegarde ait lieu, suite à quoi le module logique M est éteint. Cette durée est égale au temps minimal pour écrire sur le deuxième élément 4 à commutation résistif bipolaire, ce temps minimal étant de l'ordre de la microseconde.

D'une manière générale, le mode sauvegarde permet au deuxième élément 4 à commutation résistive bipolaire de changer d'état résistif en fonction de la sortie. Donc le deuxième élément 4 à commutation résistive bipolaire suit le fonctionnement du module logique M.

Si le premier élément 1 est un transistor, alors il doit être polarisé d'une manière modérée, c'est-à-dire avec une tension $|V_{GS}|$ entre grille et source du transistor comprise entre $|V_T|$ et ($V_{DD}-|V_T|$).

Une fois que l'opération de sauvegarde est réalisée, le mode restauration peut être déclenché à tout moment. Le procédé 100b comporte donc une troisième étape 103b de mise en oeuvre du mode restauration au cours de laquelle le dernier résultat sauvegardé est restauré sur la sortie S. Pour ce faire :

- on polarise la borne 2 non commune de la résistance ohmique 1 à une tension égale à la tension de référence VDD, et
- on polarise la borne 6 non commune du deuxième élément 4 à une tension égale à zéro.

Le mode restauration a pour fonction de restaurer l'état sauvegardé dans le mode sauvegarde en le rétablissant dans le module logique M et est effectué en conservant l'état de résistivité du deuxième élément 4.

Au cours des cycles d'horloge suivants, l'un des trois modes est déclenché, préférentiellement le mode inactif.

D'un point de vu technologique, la connexion des éléments à commutation résistive bipolaire ainsi que l'arrivée de leur ligne d'alimentation MVDD et MVSS peuvent être réalisées de façon non limitative selon l'une des trois variantes de métallisation qui sont illustrées aux figures 6, 7 et 8.

La figure 6 illustre un quatrième mode de réalisation non limitatif d'un module logique M conforme à l'invention.

Le module logique M comporte :

- des moyens de mise en oeuvre d'une fonction logique MF, les moyens MF comportant quatre entrées E1, E2, E3, E4 et deux sorties S1, S2,
- deux premiers éléments 1, chacun étant formé par une mémoire résistive bipolaire comportant une première électrode 2 et une deuxième électrode 3, et
- deux deuxièmes éléments 4, chacun étant formé par une mémoire résistive bipolaire comportant une troisième électrode 5 et une quatrième électrode 6.

On notera que le nombre d'entrée et le nombre de sortie ont été donnés ici à titre purement illustratif étant entendu que le nombre d'entrée peut être supérieur ou inférieur à 4 et que le nombre de sortie peut être inférieur ou supérieur à 2.

Dans cet exemple un des premiers éléments 1 et un des deuxièmes éléments 4 présentent une électrode commune formée par la deuxième électrode 3 et la troisième électrode 5 ; la deuxième électrode 3 et la troisième électrode 5 communes sont en outre reliées à une sortie S1 du module MF. Il convient de noter que le premier élément 1 et le deuxième élément 4 sont agencés en série et selon un même sens de polarité.

En outre, l'autre des premiers éléments 1 et l'autre des deuxièmes éléments 4 présentent également une électrode commune formée par la deuxième électrode 3 et la troisième électrode 5 ; la deuxième électrode 3 et la troisième électrode 5 communes sont en outre reliées à une autre sortie S2 du module MF. Il convient de noter que cet autre premier élément 1 et cet autre deuxième élément 4 sont agencés en série et selon un même sens de polarité.

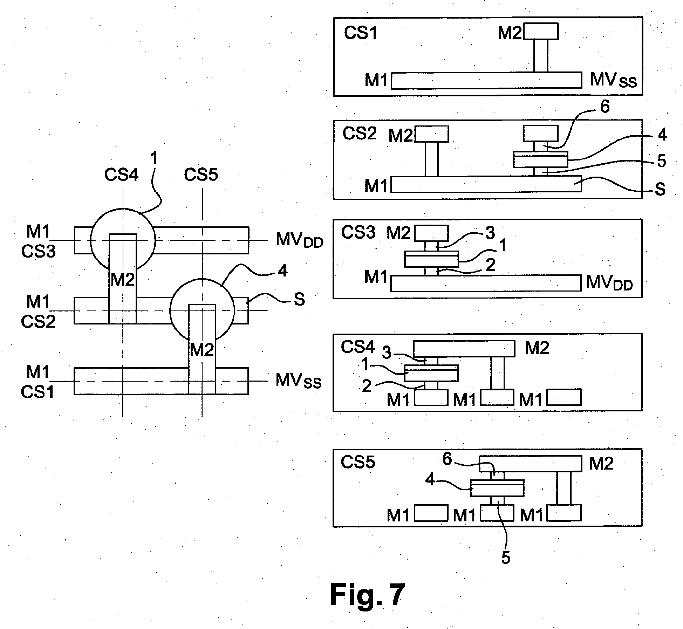

La figure 7 illustre un premier mode de réalisation des niveaux de métallisation d'un module selon l'invention. La figure 7 comporte notamment cinq vues en coupe CS1, CS2, CS3, CS4 et CS5.

La technologie utilisée présente deux niveaux de métallisation M1 et M2, le premier élément 1 et le deuxième élément 4 étant disposés entre le premier niveau de métallisation M1 et le deuxième niveau de métallisation M2, le premier niveau de métallisation M1 étant le niveau de métallisation le plus bas.

Dans cette réalisation, l'électrode 2 du premier élément 1 différente de l'électrode commune (formée par les électrodes 3 et 5) est connectée au premier niveau de métallisation M1 sur lequel est également formé dans ce cas MVDD (Cf. vues en coupe CS3 et CS4).

En outre, l'électrode 6 du deuxième élément 4 différente de l'électrode commune (formée par les électrodes 3 et 5) est connectée indirectement au premier niveau de métallisation M1 sur lequel est également formé MVSS, cette connexion étant réalisée via le deuxième niveau de métallisation M2 connecté à la fois à l'électrode 6 et au premier niveau de métallisation M1 (Cf. vue en coupe CS5).

En outre, la sortie S est également formée sur le premier niveau de métallisation M1 et est connectée directement à l'électrode 5 (Cf. vue en coupe CS2) et indirectement à l'électrode 3 via le deuxième niveau de métallisation M2.

Dans cette réalisation, des éléments à commutation résistive bipolaire RRAM de type OxRAM présentant des électrodes non-solubles peuvent être employés.

Avantageusement, comme les deux éléments à commutation résistive bipolaire sont disposés entre les premier et deuxième niveaux de métallisation M1 et M2, la densité d'intégration est élevée.

En outre, cette mise en oeuvre est compatible avec les designs actuels puisque les modules logiques standards sont dessinés jusqu'au premier niveau de métallisation. Le placement et le routage sont réalisés à partir du deuxième niveau de métallisation au moyen des outils de dessin de type CAD. Il est envisageable d'utiliser les modules logiques contenus dans une librairie de design et de rajouter le dessin des couples d'éléments à commutation résistive bipolaire à la sortie du module logique contenu dans la librairie. Il s'agit donc d'une modification minime de la librairie qui ne nécessite aucun outil de conception performant ou coûteux. Il est en revanche indispensable de prendre en compte la présence des deux rails de MVSS et MVDD sur le deuxième niveau de métallisation qui se rajoutent à ceux de VDD et VSS naturellement présents dans les modules standards de la librairie de départ.

On notera que l'utilisation d'un point mémoire RRAM avec électrode soluble (du type CBRAM) en argent n'est pas compatible. Un dispositif RRAM bipolaire de type OxRRAM avec électrodes non-solubles peut en revanche être employé.

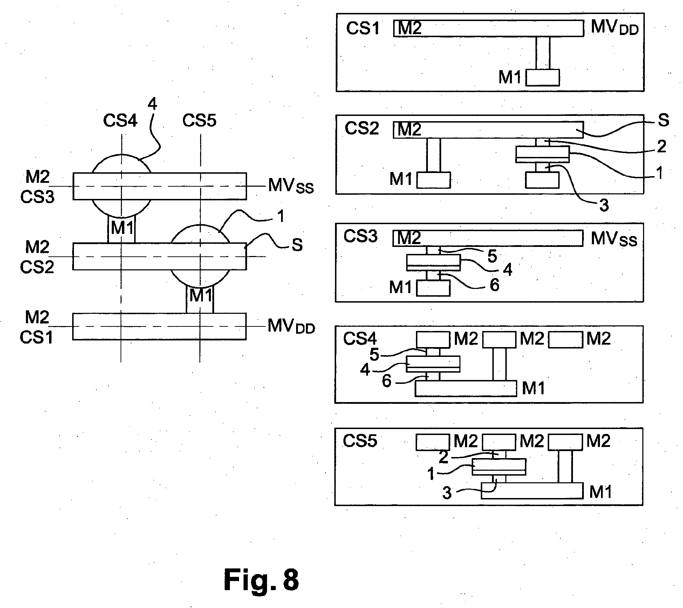

La figure 8 illustre un deuxième mode de réalisation des niveaux de métallisation d'un module selon l'invention. La figure 8 comporte cinq vues en coupe CS1, CS2, CS3, CS4 et CS5.

Dans cette réalisation, le premier élément 1 et le deuxième élément 4 sont disposés entre le premier niveau de métallisation M1 et le deuxième niveau de métallisation M2.

L'électrode 2 du premier élément 1 différente de l'électrode commune (formée par les électrodes 3 et 5) est connectée au deuxième niveau de métallisation M2 formant MVDD (Cf. vue en coupe CS2).

En outre, l'électrode 6 du deuxième élément 4 différente de l'électrode commune (formée par les électrodes 3 et 5) est connectée indirectement au deuxième niveau de métallisation M2, le deuxième niveau de métallisation formant dans ce cas MVSS. Cette connexion est réalisée via le premier niveau de métallisation M1 qui est connecté à la fois à l'électrode 6 (Cf. vue en coupe CS3) et au deuxième niveau de métallisation M2 formant MVSS (Cf. vue en coupe CS4).

En outre, la sortie S est également formée par le deuxième niveau de métallisation M2 et est connectée directement à l'électrode 2 (Cf. vue en coupe CS2) et à l'électrode 3 via le premier niveau de métallisation M1 qui est connecté directement à l'électrode 5 (Cf. vue en coupe CS5) et au deuxième niveau de métallisation M2 formant la sortie S.

Cette variante présente des avantages identiques à ceux conférés par le premier mode de réalisation illustré sur la figure 7.

Avantageusement, l'utilisation du deuxième niveau de métallisation M2 pour réaliser les lignes MVDD et MVSS permet d'obtenir une densité d'intégration élevée (environ 25% plus dense).

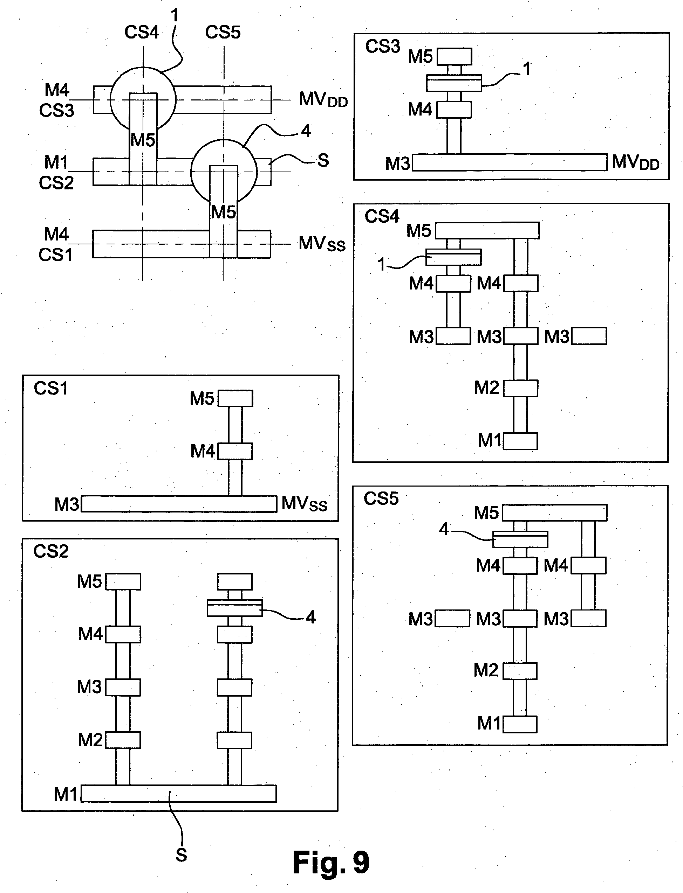

La figure 9 illustre un troisième mode de réalisation des niveaux de métallisation d'un module selon l'invention. La figure 9 comporte notamment cinq vues en coupe CS$_1$, CS2, CS$_3$, CS4 et CS5.

La technologie utilisée présente cinq niveaux de métallisation M1 à M5.

Dans cette réalisation, le premier élément 1 et le deuxième élément 4 sont disposés entre l'avant dernier niveau de métallisation (i.e. le quatrième niveau de métallisation M4 dans l'exemple illustré) et le dernier niveau de métallisation (i.e. le cinquième niveau de métallisation M5 dans l'exemple illustré).

Dans cette réalisation, chaque élément à commutation résistive bipolaire est fabriqué avant le dernier niveau de métallisation afin d'influer le moins possible sur les étapes de fabrication des interconnexions inférieures utilisées pour les éléments de circuit logique. Dans ce cas, en limitant la température de fabrication du dernier niveau de métallisation M5 à environ 300 ° C, des éléments à commutation résistive bipolare de type CBRAM avec électrode soluble en Argent peuvent être employés.

Il est entendu que l'homme du métier est à même de réaliser différentes variantes de l'invention, notamment en ce qui concerne la disposition et la connexion des premier et deuxième éléments 1, 4 avec les niveaux de métallisation sans pour autant sortir du cadre de l'invention.

**Revendications**

1. Module logique (M) comportant:

    - des moyens de mise en oeuvre d'une fonction logique (MF), lesdits moyens (MF) comportant au moins une entrée (E1, E2) et au moins une sortie (S), ladite au moins une sortie (S) représentant au moins partiellement le résultat de ladite fonction logique,
    - au moins un premier élément (1) comportant au moins un état résistif,
    - au moins un deuxième élément (4) formé par une mémoire résistive bipolaire,
    - ledit premier élément (1) et ledit deuxième élément (4) ayant une électrode commune (3, 5) reliée à ladite sortie (S).

2. Module logique (M) selon la revendication précédente **caractérisé en ce que** le premier élément (1) est une résistance ohmique ou un transistor.

3. Module logique (M) selon la revendication 1 **caractérisé en ce que** le premier élément (1) est une mémoire résistive bipolaire, le premier élément (1) et le deuxième élément (4) étant agencés en série et selon un sens identique de polarité.

4. Module logique (M) selon la revendication précédente **caractérisé en ce que** les tensions appliquées sur les électrodes respectives non communes (3, 5) desdits premier et deuxième éléments (1, 4) sont programmées selon un ou plusieurs cycles d'horloge de sorte que le module logique (M) présente trois modes de fonctionnement :

    - un mode inactif au cours duquel le premier élément (1) et le deuxième élément (4) sont dans un état de haute résistance, dit état résistif haut (OFF) de sorte que lesdits premier et deuxième éléments (1, 4) ne perturbent pas la mise en oeuvre de la fonction logique ;
    - un mode de sauvegarde au cours duquel le dernier résultat de la fonction logique est sauvegardé en fonction d'un état résistif donné desdits premier élément (1) et deuxième élément (4) ;
    - un mode de restauration suivant le mode de sauvegarde au cours duquel le dernier résultat sauvegardé est restauré sur ladite sortie (S).

5. Module logique (M) selon l'une des revendications précédentes **caractérisé en ce que** chaque mémoire résistive bipolaire est choisie parmi les mémoires suivantes :

    - mémoire CBRAM ;
    - mémoire OxRAM bipolaire;
    - mémoire MEMS;
    - mémoire NEMS.

6. Module logique (M) selon l'une des revendications précédentes **caractérisé en ce que** le premier élément (1) et le deuxième élément (4) sont disposés entre un premier niveau de métallisation (M1) et un deuxième niveau de métallisation (M2), le premier niveau de métallisation (M1) étant le niveau de métallisation le plus bas.

7. Module logique (M) selon la revendication 6 précédente **caractérisé en ce que**,

    - l'électrode (2) du premier élément (1) différente de l'électrode commune est connectée au premier niveau de métallisation (M1), ledit premier niveau de métallisation (M1) formant l'arrivée de la ligne d'alimentation (MVDD),
    - l'électrode (6) du deuxième élément (4) différente de ladite électrode commune est connectée au premier niveau de métallisation (M1), ledit premier niveau de métallisation (M1) formant l'arrivée de la ligne d'alimentation (MVSS), et
    - ladite sortie (S) est formée par le premier niveau de métallisation.

8. Module logique (M) selon la revendication 6 **caractérisé en ce que**,

    - l'électrode (2) du premier élément (1) différente de l'électrode commune (3, 5) est connectée au deuxième niveau de métallisation (M2), ledit deuxième niveau de métallisation (M2) formant l'arrivée de la ligne d'alimentation (MVDD) ;
    - l'électrode (6) du deuxième élément (2) différente de ladite électrode commune (3, 5) est connectée au deuxième niveau de métallisation (M2), ledit deuxième niveau de métallisation (M2) formant l'arrivée de la ligne d'alimentation (MVSS) ; et
- ladite sortie (S) est formée par le deuxième niveau de métallisation (M2) et est connectée à l'électrode commune (3, 5).

9. Module logique (M) selon l'une des revendications 1 à 5 **caractérisé en ce que** le premier élément (1) et le deuxième élément (4) sont disposés entre deux niveaux de métallisation intermédiaires ou supérieurs.

10. Module logique (M) selon l'une quelconque des revendications précédentes **caractérisé en ce qu'**il comporte :

- une pluralité de sorties (S), ladite pluralité de sortie (S) représentant le résultat de ladite fonction logique,
- une pluralité de premiers éléments (1),
- une pluralité de deuxièmes éléments (4),
- chaque sortie (S) étant reliée à une électrode commune (3, 5) d'un premier élément (1) et d'un deuxième élément (4).

**Patentansprüche**

1. Logikmodul (M), aufweisend:

- Mittel zum Ausführen einer logischen Funktion (MF), wobei die Mittel (MF) mindestens einen Eingang (E1, E2) und mindestens einen Ausgang (S) aufweisen, wobei der mindestens eine Ausgang (S) das Ergebnis der logischen Funktion mindestens teilweise darstellt,
- mindestens ein erstes Element (1), das mindestens einen resistiven Zustand aufweist,
- mindestens ein zweites Element (4), das von einem bipolaren resistiven Speicher gebildet ist,
- wobei das erste Element (1) und das zweite Element (4) eine gemeinsame Elektrode (3, 5) haben, die mit dem Ausgang (S) verbunden ist.

2. Logikmodul (M) nach vorangehendem Anspruch, **dadurch gekennzeichnet, dass** das erste Element (1) ein ohmscher Widerstand oder ein Transistor ist.

3. Logikmodul (M) nach Anspruch 1, **dadurch gekennzeichnet, dass** das erste Element (1) ein bipolarer resistiver Speicher ist, wobei das erste Element (1) und das zweite Element (4) in Reihe und gemäß einem identischen Polaritätssinn angeordnet sind.

4. Logikmodul (M) nach vorangehendem Anspruch, **dadurch gekennzeichnet, dass** die auf die jeweiligen nicht gemeinsamen Elektroden (3, 5) des ersten und zweiten Elements (1, 4) angewendeten Spannungen gemäß einem oder mehreren Zeitzyklen derart programmiert sind, dass das Logikmodul (M) drei Betriebsmodi aufweist:

- einen inaktiven Modus, bei dem das erste Element (1) und das zweite Element (4) in einem als hoher resistiver Zustand (OFF) bezeichneten hohen Widerstandszustand sind, so dass das erste und zweite Element (1, 4) die Ausführung der logischen Funktion nicht stören,
- einen Speichermodus, bei dem das letzte Ergebnis der logischen Funktion in Abhängigkeit von einem bestimmten resistiven Zustand des ersten Elements (1) und zweiten Element (4) gespeichert wird,
- einen Wiederherstellungsmodus, der dem Speichermodus folgt, bei dem das letzte gespeicherte Ergebnis auf dem Ausgang (S) wiederhergestellt wird.

5. Logikmodul (M) nach einem der vorangehenden Ansprüche, **dadurch gekennzeichnet, dass** jeder bipolare resistive Speicher aus den folgenden Speichern ausgewählt ist:

- CBRAM-Speicher,
- bipolarer OxRAM-Speicher,
- MEMS-Speicher,
- NEMS-Speicher.

6. Logikmodul (M) nach einem der vorangehenden Ansprüche, **dadurch gekennzeichnet, dass** das erste Element (1) und das zweite Element (4) zwischen einem ersten Metallisierungsniveau (M1) und einem zweiten Metallisierungsniveau (M2) angeordnet sind, wobei das erste Metallisierungsniveau (M1) das niedrigste Metallisierungsniveau ist.

7.  Logikmodul (M) nach vorangehendem Anspruch 6, **dadurch gekennzeichnet, dass**

    - die Elektrode (2) des ersten Elements (1), die sich von der gemeinsamen Elektrode unterscheidet, mit dem ersten Metallisierungsniveau (M1) verbunden ist, wobei das erste Metallisierungsniveau (M1) die Ankunft der Versorgungsleitung (MVDD) bildet,
    - die Elektrode (6) des zweiten Elements (4), die sich von der gemeinsamen Elektrode unterscheidet, mit dem ersten Metallisierungsniveau (M1) verbunden ist, wobei das erste Metallisierungsniveau (M1) die Ankunft der Versorgungsleitung (MVSS) bildet, und
    - der Ausgang (S) vom ersten Metallisierungsniveau gebildet ist.

8.  Logikmodul (M) nach Anspruch 6, **dadurch gekennzeichnet, dass**:

    - die Elektrode (2) des ersten Elements (1), die sich von der gemeinsamen Elektrode (3, 5) unterscheidet, mit dem zweiten Metallisierungsniveau (M2) verbunden ist, wobei das zweite Metallisierungsniveau (M2) die Ankunft der Versorgungsleitung (MVDD) bildet,
    - die Elektrode (6) des zweiten Elements (2), die sich von der gemeinsamen Elektrode (3, 5) unterscheidet, mit dem zweiten Metallisierungsniveau (M2) verbunden ist, wobei das zweite Metallisierungsniveau (M2) die Ankunft der Versorgungsleitung (MVSS) bildet, und
    - der Ausgang (S) vom zweiten Metallisierungsniveau (M2) gebildet ist und mit der gemeinsamen Elektrode (3, 5) verbunden ist.

9.  Logikmodul (M) nach einem der Ansprüche 1 bis 5, **dadurch gekennzeichnet, dass** das erste Element (1) und das zweite Element (4) zwischen zwei Übergangs- oder höheren Metallisierungsniveaus angeordnet sind.

10. Logikmodul (M) nach einem der vorangehenden Ansprüche, **dadurch gekennzeichnet, dass** es aufweist:

    - eine Vielzahl von Ausgängen (S), wobei die Vielzahl von Ausgängen (S) das Ergebnis der logischen Funktion darstellt,
    - eine Vielzahl erster Elemente (1),
    - eine Vielzahl zweiter Elemente (4),
    - wobei jeder Ausgang (S) mit einer gemeinsamen Elektrode (3, 5) eines ersten Elements (1) und eines zweiten Elements (4) verbunden ist.

**Claims**

1.  A logic module (M) including:

    - means for implementing a logic function (MF), said means (MF) including at least one input (E1, E2) and at least one output (S), said at least one output (S) representing at least partially the result of said logic function,
    - at least one first element (1) including at least one resistive state,
    - at least one second element (4) formed by a bipolar resistive memory,
    - said first element (1) and said second element (4) having a common electrode (3, 5) connected to said output (S).

2.  The logic module (M) according to the preceding claim, **characterized in that** the first element (1) is an ohmic resistor or a transistor.

3.  The logic module (M) according to claim 1, **characterized in that** the first element (1) is a bipolar resistive memory, the first element (1) and the second element (4) being arranged in series and according to an identical direction of polarity.

4.  The logic module (M) according to the preceding claim, **characterized in that** the voltages applied to the respective non-common electrodes (3, 5) of said first and second elements (1, 4) are programmed according to one or more clock cycles such that the logic module (M) has three operating modes:

- an inactive mode during which the first element (1) and the second element (4) are in a high resistance state, called a high resistive state (OFF) such that said first and second elements (1, 4) do not disturb the implementation of the logic function;
- a save mode during which the last result of the logic function is saved as a function of a given resistive state of said first element (1) and second element (4);
- a restoration mode subsequent to the save mode during which the last saved result is restored on said output (S).

5. The logic module (M) according to one of the preceding claims, **characterized in that** each bipolar resistive memory is chosen from the following memories:

- CBRAM memory;
- bipolar OxRAM memory;
- MEMS memory;
- NEMS memory.

6. The logic module (M) according to one of the preceding claims, **characterized in that** the first element (1) and the second element (4) are arranged between a first metallisation level (M1) and a second metallisation level (M2), the first metallisation level (M1) being the lowest metallisation level.

7. The logic module (M) according to the preceding claim 6, **characterized in that**,

- the electrode (2) of the first element (1) different from the common electrode is connected to the first metallisation level (M1), said first metallisation level (M1) forming the intake of the supply line (MVDD),
- the electrode (6) of the second element (4) different from said common electrode is connected to the first metallisation level (M1), said first metallisation level (M1) forming the intake of the supply line (MVSS), and
- said output (S) is formed by the first metallisation level.

8. The logic module (M) according to claim 6, **characterized in that**,

- the electrode (2) of the first element (1) different from the common electrode (3, 5) is connected to the second metallisation level (M2), said second metallisation level (M2) forming the intake of the supply line (MVDD),
- the electrode (6) of the second element (2) different from said common electrode (3, 5) is connected to the second metallisation level (M2), said second metallisation level (M2) forming the intake of the supply line (MVSS), and
- said output (S) is formed by the second metallisation level (M2) and is connected to the common electrode (3, 5).

9. The logic module (M) according to one of claims 1 to 5, **characterized in that** the first element (1) and the second element (4) are disposed between two medium or higher metallisation levels.

10. The logic module (M) according to any of the preceding claims, **characterized in that** it includes:

- a plurality of outputs (S), said plurality of outputs (S) representing the result of said logic function,
- a plurality of first elements (1),
- a plurality of second elements (4),
- each output (S) being connected to a common electrode (3, 5) of a first element (1) and of a second element (4).

Fig. 1

Fig. 2

Fig. 3

Fig. 4

100b

-101b-

-102b-

-103b-

Fig. 5

M

MVSS

E1    MF                              6

                                      4
                                      5        S1
                                      3
                                      1
E2                                    2

                              MVDD

                              MVSS

E3                                    6

                                      4
                                      5        S2
                                      3
                                      1
E4                                    2

                              MVDD

Fig. 6

**Fig. 7**

# Fig. 8

**Fig. 9**